(19) Europäisches Patentamt
European Patent Office
Office européen des brevets

(11) EP 1 575 082 A2

(12) **EUROPEAN PATENT APPLICATION**

(43) Date of publication:
**14.09.2005 Bulletin 2005/37**

(51) Int Cl.[7]: **H01L 21/3213**, H01L 21/28, H01L 21/335, H01L 21/306

(21) Application number: **04447208.2**

(22) Date of filing: **24.09.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **08.03.2004 US 551543**

(71) Applicant: **Interuniversitair Micro-Elektronica Centrum (IMEC)**
**3001 Heverlee (BE)**

(72) Inventors:
- **Demeurisse, Caroline**
  **3001 Leuven (BE)**
- **Opsomer, Karl**
  **9890 Gavere (BE)**

(74) Representative: **Van Malderen, Joelle et al**
**pronovem - Office Van Malderen**
**Avenue Josse Goffin 158**
**1082 Bruxelles (BE)**

(54) **Method for formimg a self-aligned germanide structure**

(57) The present invention relates to a method for forming a germanide structure in a self-aligned way in a germanium region on a semiconductor substrate which comprises the steps of depositing a layer of a metal over the substrate and the germanium region, heating the structure to form a compound of the metal and the germanium and selectively removing the unreacted metal from the formed germanide and the substrate.

The present invention discloses the use of hydrohalides for removing a metal selectively from the compound layer resulting from the reaction between this metal and germanium.

In a preferred embodiment Nickel is used as metal to form a nickel germanide and HCl is used as etchant to selectively remove Nickel.

Figure 1

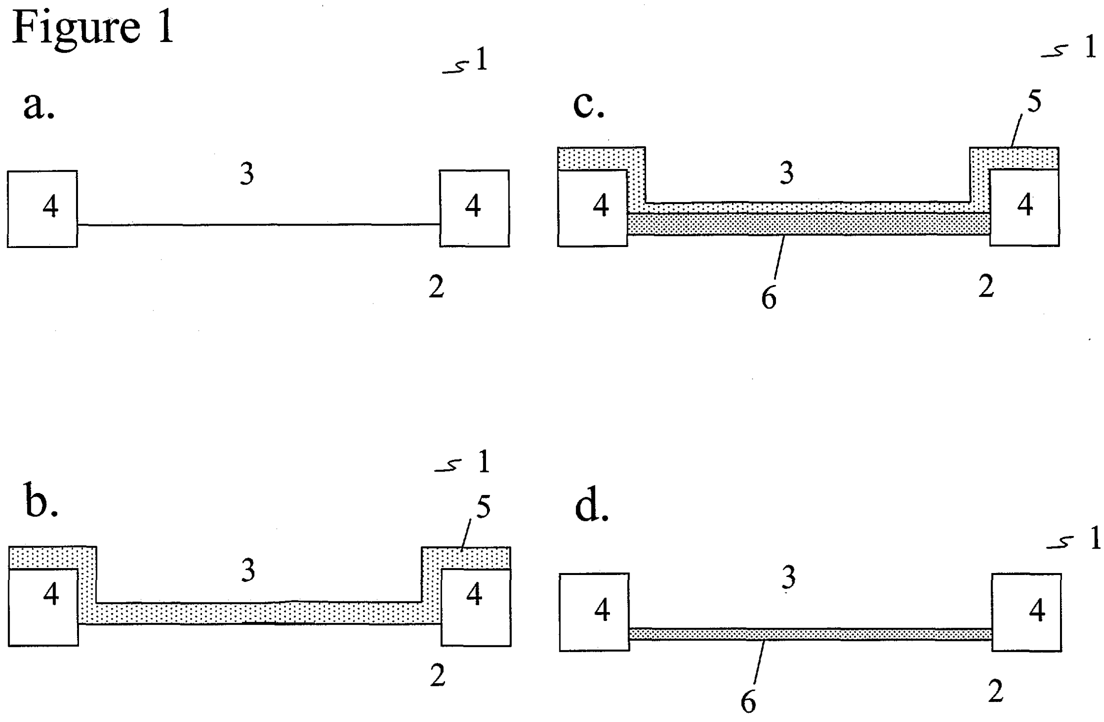




Printed by Jouve, 75001 PARIS (FR)

## Description

### Field of the Invention

The present invention is related to the field of semiconductor processing.

The present invention is related to the field of forming germanides, a compound of germanium and a metal, in a self-aligned way comprising the step of selectively removing the unreacted portion of a metal from said germanide, germanium and the dielectricum.

The present invention relates to a composition and its use for selectively removing the unreacted portion of the metal from the germanide, the germanium layer and/or dielectric material.

### Background

In order to modify the electronic properties of a semiconductor element, e.g. to reduce the resistivity of a semiconductor region in a substrate, to change the work-function of a semiconductor gate electrode formed upon this substrate, a metal is deposited at least over this semiconductor element.

The stack consisting of said metal and semiconductor material is then heated resulting in a semiconductor-metal compound layer, which shows a lower resistivity than the resistivity of the starting semiconductor material, or which has a work-function different from the initial one.

Unreacted metal is removed from the substrate, at least selectively to the semiconductor-metal compound, thereby leaving only the semiconductor-metal compound layer.

The semiconductor metalide layer obtained after the step of selectively removing the unreacted metal without performing any masking step is often referred to as a self-aligned structure.

Optionally an additional heating step is performed to further reduce the resistivity of the semiconductor metalide layer, e.g. by changing the crystal phase of this layer.

Examples of such semiconductor-metal compound are silicides.

Metal silicide thin films are commonly used in microelectronic circuits for a variety of applications such as interconnects, contacts and for the formation of transistor gates. Titanium disilicide ($TiSi_2$), Cobalt disilicide ($CoSi_2$), or Nickel silicide (NiSi) are preferentially used in Ultra Large Scale Integrated Semiconductor devices having submicron design rules.

The silicide layer has a lower sheet resistance than the sheet resistance of silicon.

US 5,780,362 discloses an example of self-aligned silicide technology (also called Salicide Technology). The metal, i.e. Co, Ti, is first deposited followed by a thermal treatment step to form the silicide on the regions of the semiconductor substrate where silicon is exposed. The non-silicided metal remaining on the dielectric surface is then selectively etched, e.g. by an aqueous solution of sulfuric acid ($H_2SO_4$) and/or ammonium hydroxide ($NH_4OH$).

Because the silicide is formed only on those regions where silicon is exposed, and since the remaining metal can be selectively etched without a masking step, the structure formed by this process is referred to as self aligned.

Due to its electronic properties, germanium is, in various MOS technologies, considered as a replacement to silicon as semiconductor material of choice to form the substrate and/or the gate electrode.

Germanides, i.e. a compound resulting from the reaction between germanium and a metal, e.g. Ni, are used to either reduce the resistivity of the source and drain regions or of the gate electrode or to modify the work-function of this gate electrode.

D.S Yu et al discuss in "$Al_2O_3$-Ge-On-Insulator n- and p-MOSFETS with fully NiSi and NiGe dual gates", published in IEEE electron device letters, vol. 25, No 3, March 2004, p 138-140, the electrical performance of nMOS and pMOS devices with fully silicided NiSi and germanided NiGe dual gates, fabricated on a Germanium-On-Insulator (GOI) substrate. The NiSi and NiGe gates were formed by first depositing respectively 15 nm amorphous Si or Ge on the high-k dielectric, which is used as gate dielectric, then depositing 15 nm Ni and then annealing at 400°C for 30 sec. for silicidation or germanidation, respectively. However Yu et al do not disclose the selective removal of the Ni from the NiGe gate or from the Ge substrate.

### Summary of the Invention

It was found that a composition comprising hydrohalides, in particular an aqueous solution of hydrohalides, e.g. HCl, could selectively remove the unreacted part of a metal e.g. Ni from the germanium and/or germanide layer and/or dielectric material.

The present invention provides a composition comprising one or more hydrohalide(s), and optionally $H_2SO_4$, and its use for removing unreacted metal(s), e.g. Ni, from the germanium layer, the germanide layer and/or the dielectric layer.

Other preferred metals that are considered to form a metal-germanide compound in a self-aligned way are metals such as Ti, Co, Pt, Pd, Ru,....

The present invention also provides a method for forming a self-aligned germanide comprising the step of selectively removing unreacted metal(s) from the germanium layer, the germanide layer and/or the dielectric layer, by contacting said unreacted metal(s) with a composition, heated or not, comprising one or more hydrohalides, and optionally $H_2SO_4$.

Another object of the present invention is a semiconductor device comprising a self-aligned germanide from which unreacted metal(s) has been removed by means of a composition comprising one or more hydrohalides, and optionally $H_2SO_4$.

## Brief Description of the Drawings

All drawings are intended to illustrate some aspects and embodiments of the present invention. Devices are depicted in a simplified way for reason of clarity. Not all alternatives and options are shown and therefore the invention is not limited to the content of the given drawings. Like numerals are employed to reference like parts in the different figures.

Figures 1a-d illustrate by means of schematic cross-sections a process flow according to an embodiment of the invention.

Figures 2a-e illustrate, by means of schematic cross-sections, a process flow according to an embodiment of the invention.

Figure 3 shows the sheet resistance as function of the annealing temperature of germanides formed upon (a) undoped germanium (b) doped germanium.

Figure 4 illustrates the etch rate of Ni (a) and Ni-Germanide (b) with an HCl:$H_2O$ etch composition with different HCl concentrations.

Figures 5 (a) and (b) illustrate the etch rate of Ni (a) and Ni-Germanide (b) as a function of temperature in an HCl:$H_2O$ (1:3) composition used for etching. Complete removal of Ni (initial thickness of 50 nm) is achieved after 120 sec. at a temperature of 60 °C.

Figure 5 (c) shows the Arhennius plot for the selective etching of Nickel with an HCl:$H_2O$ (1:3) composition. The reaction where the metal is removed from the surface of the sample can be characterized by the activation energy Ea. The rate r of the reaction in which the metal is etched and dissolved in the etching composition can be expressed by the following equation:

$$r = A\exp\left(\frac{-E_a}{kT}\right)$$

Having regard to the temperature dependence of the reaction, it can be inferred that a high temperature will result in more dissolved metal when -Ea<0. If -Ea>0, a low temperature will result in more dissolved metal. By plotting ln (r) versus T, a straight line is obtained in the ideal case, where the slope gives a value of the activation energy. In this case the value for Ea is 2.2eV.

Figure 5 (d) and (e) illustrate the etch rate of Ni (d) and Ni-Germanide (e) as a function of temperature in an HCl:$H_2O$ (1:7) composition used for etching. Complete removal of Ni (initial thickness of 50 nm) is also achieved after 120 sec. at a temperature of 60 °C. The etch rates achieved with the 1:7 HCl:$H_2O$ etch mixture compared to the results of selective etching with an 1:3 (HCl:$H_2O$) are comparable with respect to etch rate of the Ni but the 1:7 (HCl:$H_2O$) etch mixture has a higher selectivity towards the germanide.

Figure 6 illustrates the etch rate of Ni (a) and Ni-Germanide (b) as a function of temperature in an HCl:$H_2SO_4$:$H_2O$ (1:0.5:3) composition used for etching. Complete removal of Ni (initial thickness of 50 nm) is achieved after 60 sec. at a temperature of 70 °C. Compared to Figure 5b there is however attack (etching) of the Ni-Germanide due to the presence of hot (70 °C) $H_2SO_4$. Figure 6 (c) shows the Arhennius plot for the selective etching of Nickel with HCl:$H_2SO_4$:$H_2O$ (1:0.5:3). The value for Ea is 1.5eV which is lower than the Ea value obtained with a HCl:$H_2O$ (1:3) etch mixture.

Figure 7 illustrates the etch rate of Ni (a) and Ni-Germanide (b) with an HBr:$H_2O$ etch composition with different HBr concentrations. The etch rate of Nickel is very slow. Higher concentrations of HBr and higher temperatures should increase etch rate.

Figure 8 illustrates the etch rate of Ni (a) and Ni-Germanide (b) with an HF:$H_2O$ etch solution with different HF concentrations. Complete removal of Ni is achieved within 360 seconds with an HF:$H_2O$ mixture equal to 1:9. Preferably, HF is not used where the dielectric material is $SiO_2$.

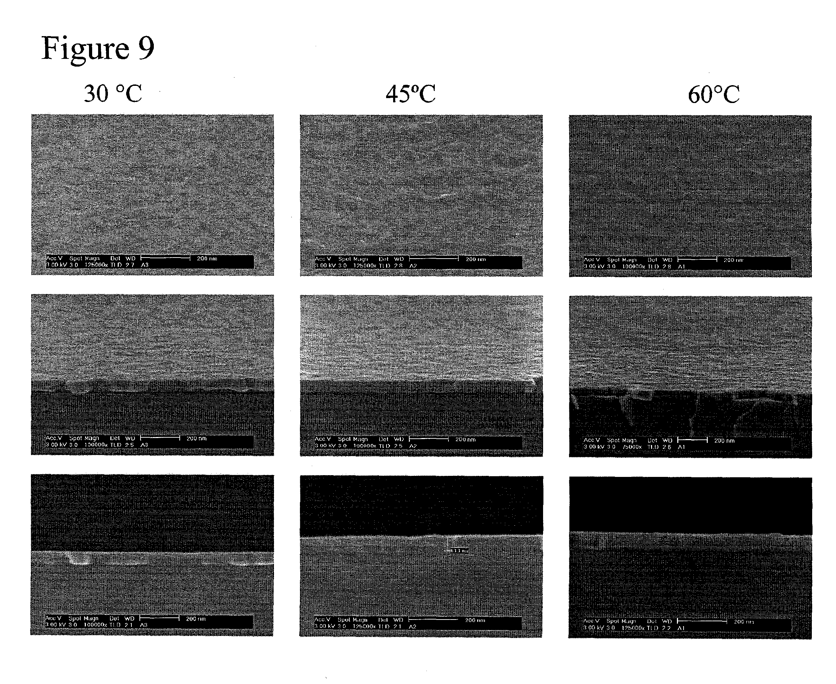

Figure 9 illustrates the SEM pictures of Ni-Germanide surface subjected to an HCl:$H_2O$ mixture of 1:3 at different temperatures. No damage of the NiGe surface was observed. The NiGe surface was dipped in the etch mixture for 120 seconds but even longer contact times did not affect the NiGe surface.

## Detailed Description of the Invention

The present invention provides a composition and its use for substantially and selectively removing unreacted metal(s) from a germanium layer, a germanide layer and/or a dielectric layer, without affecting said layer(s), said composition comprising at least one hydrohalide, preferably selected from the group consisting of HF, HCl, HBr and HI, and optionally $H_2SO_4$.

In the context of the present invention, the term "selective removal of a metal" or "selective etching of a metal", or the term "metal selectively removed", refers to the substantial removal of said metal from its support (e.g. from a germanide layer) without affecting (substantially) said support.

The term "substantial" or "substantially" when it refers to the removal (etch) of a metal, means that more than 95% of the metal layer is removed, more preferably 98% of the metal layer is removed and most preferably 99% of the metal layer is removed.

A composition according to the present invention comprises or consists of at least one hydrohalide, preferably selected from the group consisting of HF, HCl, HBr and HI, and optionally $H_2SO_4$.

According to the invention, a composition for removing the unreacted metal(s) from a germanium layer, a germanide layer and/or a dielectric layer, may also comprise an aqueous solution of at least two hydrohalides selected from the group consisting of HF, HCl, HBr and HI, and optionally $H_2SO_4$.

A composition of the invention may also comprise or consist of:

- an aqueous solution of at least one hydrohalide selected from the group consisting of HF, HCl, HBr and HI, and
- a solution of $H_2SO_4$, and/or
- a solution of $NH_4OH$, and/or
- a solution of $H_3PO_4$.

In a preferred composition of the invention, the solutions are dilutions from commercially available hydrohalides solutions, which are commonly used in VLSI (Very Large Scale Integration) processing.

Herein the HCl starting solution can be a 37 wt % concentrated solution, which can be use as such for selectively removing the unreacted metal from a germanium layer, a germanide layer and/or a dielectric layer.

Herein the $H_2SO_4$ starting solution can be a 95-97 wt % concentrated solution.

Herein the HF starting solution can be a 49 wt% concentrated solution.

Herein the HBr starting solution can be a 48 wt% concentrated solution.

The concentration of the different components in a composition of the invention can be expressed as a x:y ratio or x:y:z ratio wherein x, y and z are real numbers and refer to volumetric part for each component. For example, an HCl:$H_2O$ (1:3) composition means a composition consisting of 1 volumetric part of the HCl starting solution with 3 parts of $H_2O$ mixed together.

The concentration of the different components in a composition of the invention can also be expressed in terms of wt %.

A preferred composition of the invention for selectively removing one or more metals from a germanium layer, a germanide layer and/or a dielectric layer comprises less than about 25% of HF based on the total weight of the composition, preferably less than about 12 wt.%, more preferably less than about 6 wt.%.

A preferred composition of the invention for selectively removing one or more metals from a germanium layer, a germanide layer and/or a dielectric layer comprises less than about 48% of HBr based on the total weight of the composition, preferably less than about 32 wt.%, more preferably less than about 24 wt.%.

A preferred composition of the invention for selectively removing one or more metals from a germanium layer, a germanide layer and/or a dielectric layer comprises less than about 20% of HCl based on the total weight of the composition, preferably less than about 15 wt.%, more preferably less than about 10 wt.%.

A composition of the invention may further comprise less than about 50 wt. % of $H_2SO_4$, preferably less than about 30 wt.%, more preferably less than about 20 wt.%.

A composition comprising any combination of two or more of these hydrohalides in these specified concentrations, optionally with $H_2SO_4$, is also contemplated.

A composition according to the invention can be used for selectively removing unreacted metal(s) from the germanium layer, the germanide layer and/or the dielectric layer.

Therefore, a method for selectively removing unreacted metal(s) from the germanium layer, the germanide layer and/or the dielectric layer, comprises the step of contacting said unreacted metal(s) with a composition comprising one or more hydrohalides, and optionally $H_2SO_4$.

In a preferred method of the invention an aqueous solution of HCl is used to selectively remove unreacted Ni from nickel-germanide (NiGe), from germanium (Ge) and/or from the dielectricum (e.g. the oxide).

This HCl:$H_2O$ composition, consisting of an aqueous solution of HCl, has a ratio between 1:0 and 1:24, i.e. dilution of commercially available HCl solution of 11.9 Molar/liter or 37 wt %, in a ratio of 1 part HCl and 0 part $H_2O$ (1: 0) up to a ratio of 1 part HCl and 24 parts $H_2O$ (1:24).

The temperature of a composition comprising at least one hydrohalide, preferably selected from the group consisting of HF, HCl, HBr and HI, and optionally $H_2SO_4$, has an effect on the etch rate.

A preferred method of the invention, for selectively removing unreacted metal(s) from the germanium layer, the germanide layer and/or the dielectric layer, comprises the step of contacting said unreacted metal(s) with a composition comprising one or more hydrohalides, and optionally $H_2SO_4$, said composition being at a temperature comprised between about 18°C (further referred to as (clean)room temperature and means the temperature of the solution without additional heating of the solution, the solution will thus have the temperature of the environment which is in the case of semiconductor processing the cleanroom) and about 100°C, preferably between about 50°C and about 80°C, and more preferably between about 60°C and about 75°C.

For example, in a method of the invention, a 1:0 HCl/$H_2O$ composition, at (clean)room temperature, removes 10 nm Ni in about 30 sec..

As another example, a 1:1 HCl:$H_2O$ composition removes 50 nm Ni in about 4 minutes. The HCl:$H_2O$ composition of 1:1 has an etch selectivity to NiGe compared to Ni of 1/20. Substantially all the unreacted Ni is removed in less than 60 seconds. Etch selectivity is expressed as etch rate of unreacted metal (Ni) expressed in nm/min. towards the etch rate of the metal-germanide (Ni-Ge) expressed in nm/min..

The temperature of the composition is preferably between (clean)room temperature (i.e. about 18°C, about 19°C, about 20°C or about 21°C) and about 100 °C.

Increasing the temperature of the composition increases the etch rate of Ni such that lower HCl concentrations can be used without reducing the etch rate and the Ni germanide surface is less subject to possible surface damage due to more concentrated and thus more aggressive etch compositions.

Figure 5a shows the effect of increasing the temperature of a HCl:$H_2O$ (1:3) etch composition on the etch rate of unreacted Ni on the surface.

In one embodiment, a small amount of $H_2SO_4$, e.g. less than 20 wt%, is added to an HCl solution, and the resulting composition is used at temperatures lower than 50°C and preferably at (clean)room temperature. Compared to a composition consisting of HCl:$H_2O$ used also at (clean)room temperature, a composition further comprising $H_2SO_4$ shows a higher etch rate of unreacted Ni but no extra improvement towards etch selectivity is observed.

A preferred HCl:$H_2SO_4$:$H_2O$ composition has a volumetric ratio of HCl from $H_2SO_4$ comprised between 1:0,1 and 1:1 and preferably 1:0,5. A preferred HCl:$H_2SO_4$:$H_2O$ composition has a volumetric ratio of 1:0,5:3.

A composition of the invention comprising (less than 20%) $H_2SO_4$ is preferably used between about 18° and about 50°C, because at higher temperatures, e.g. 70° C, $H_2SO_4$ etches NiGe, in other words the composition looses its selective property.

In a best mode embodiment, a diluted and heated HCl:$H_2O$ mixture is preferred as etching composition for the selective etching of Ni from Ni Germanide. More preferably, the composition comprises 1 part HCl and 7 parts $H_2O$ and is heated to improve the etch rate of Nickel. The temperature of said composition is preferably between about 50° and about 75 °C and more preferably at about 70°C.

The use a HCl:$H_2O$ composition with a volumetric ratio of 1:7, at 60°C, removes substantially all unreacted Ni in about 120 seconds. This result is identical with respect to etching rate with a 1:3 (HCl:$H_2O$) mixture but not with respect to etch selectivity: the 1:7 etch mixture has a much higher selectivity. The etch selectivity of the preferred etch mixture of 1:7 (HCl:$H_2O$) is 101.

Also provided is a method for forming a self-aligned germanide comprising the step of selectively removing unreacted metal(s) from the germanide layer and optionally from the germanium layer and/or from the dielectric layer, by contacting said unreacted metal(s) with a composition comprising one or more hydrohalides, and optionally $H_2SO_4$.

In a preferred method for forming a self-aligned germanide, said composition comprising one or more hydrohalides, and optionally $H_2SO_4$, is contacted with the metal(s) at a temperature comprised between about 18°C and about 100°C, preferably between about 50°C and about 75°C, and more preferably between about 60°C and about 70°C.

A method for forming a self-aligned germanide according to the invention may comprise the steps of:

- providing a substrate comprising at least one region in which germanium is exposed,
- depositing a metal, preferably Ni, at least over the exposed germanium in this region,

- heating the substrate to form a germanide, and
- removing the unreacted metal by contacting a composition comprising one or more hydrohalides, and optionally $H_2SO_4$, preferably at a temperature comprised between about 18°C and about 100°C, preferably between about 50°C and about 75°C, and more preferably between about 60°C and about 70°C.

The unreacted metal is selectively removed from the germanide, from the substrate and/or from the dielectric materials, which might be present on the substrate.

Figure 1a-b illustrates a process flow according to an embodiment of the present invention. A substrate (1) is provided which comprises at least one region (3) formed in a germanium layer (2) as illustrated by figure 1a.

This substrate (1) can be a bulk germanium wafer, in which case layer (2) is the bulk itself.

The substrate can be a Germanium-On-Insulator (GOI) wafer in which case layer (2) is the germanium layer formed upon the dielectric layer on top of the substrate.

This germanium region (3) can be formed e.g. by selectively depositing germanium on the substrate (1), at least within region (3).

More generally the substrate (1) can be any substrate on which such a germanium region (3) is formed.

The germanium layer (2) can be a continuous layer at least partially extending over the substrate (1) or can be divided in separate regions (3). These regions (3) can then be insulated from other regions by so-called field regions (4). These field regions (4) can be formed by grooves etched into the substrate (1) and which grooves are filled with a dielectric material, such as an oxide. This insulation method is also known as shallow-trench-insulation (STI).

As illustrated by figure 1b a layer (5) of a metal, preferably Ni, is deposited at least over region (3). Within region (3) the deposited metal is in contact with germanium.

As illustrated by figure 1c a heating step is performed to have the metal (5) react with the exposed germanium (3) to form a germanide (6), i.e. a compound layer of germanium (2) and the metallayer (5), at the interface between the germanium and the metal. As only part of the metal (5) reacts, unreacted metal (5) remains at least on the field regions (4).

As illustrated by figure 1d substantially all unreacted metal (5) is removed by a selective wet etch, with an etch mixture of the current invention comprising one or more hydrohalides and optionally additions of $H_2SO_4$ of the current invention, thereby leaving a germanide layer (6) in region (3). The etch mixture is at least selective to the germanide layer (6), but preferably the wet etchant also doesn't affect the dielectric material of the field regions (4) and/or the germanium of the substrate (1), e.g. by forming $Ge_xO_y$ when in contact with germanium.

Figure 2a-e illustrates another embodiment of the invention, which differs from the first embodiment, illustrated by figure 1a-d, in that a structure is present within region (3) as illustrated by figure 2a.

In case of a unipolar transistor such as a MOSFET (metal-oxide-semiconductor field effect transistor), this structure is a gate electrode comprising a conductive material (7) surrounded by spacers (8) formed in a dielectric material. On opposite sides of this gate, source (9) and drain (10) regions are formed in the germanium layer (2).

In case of a bipolar transistor, this structure can be an emitter (7) and on opposite sides of this emitter (7) external base region (9), (10) can be foreseen.

The emitter (7) is insulated form the external base (9), (10) by the dielectric material (8).

The dielectric material (8) can be an oxide, a nitride, an oxynitride such as SixOyNx with $x+y+z \leq 1$, a silicon-carbide SiC or a siliconoxycarbide SixOyCx with $x+y+z \leq 1$.

As illustrated by figure 2b a layer (5) of a metal, preferably Ni, is deposited at least over region (3), i.e. overlying the regions (9), (10) and overlying the structure (7), (8). Within region (3) the deposited metal is in contact with germanium.

As illustrated by figure 2c a heating step is performed to have the metal (5) react with the exposed germanium (3) to form a germanide (6), i.e. a compound layer of germanium (2) and the layer (5), at the interface between the germanium and the metal.

As only part of the metal (5) reacts, excess metal (5) remains on top of the germanide (6) and on the field regions (4).

As illustrated by this figure 2c no germanide is formed on top of layer (7).

As illustrated by figure 2d substantially all unreacted metal (5) is removed by a selective wet etch thereby leaving a germanide layer (6) in region (3).

The etch composition is selective at least to the germanide layer (6), but preferably the wet etchant also doesn't affect the dielectric material of the field regions (4) and/or the dielectric material (8) of the spacers and/or the germanium layer.

As illustrated by this figure 2d, germanide is only formed in the regions (9) and (10) in which germanium was in contact with the metal (5).

As illustrated by figure 2e if the structure (7) is formed from germanium also a germanide is formed on top of this structure (7).

In case of a MOS transistor formed on a GOI layer (2) having a germanium gate (7), a NiGe layer (6) can be formed in the source region (9), the drain region (10) and on the gate (7) and substantially all the unreacted Ni is removed from the entire substrate (1) by a single wet etch step. Therefore it is said that a self-aligned NiGe is formed.

On a germanium layer (2) either 10 nm Ni, 10 nm Co or 55 nm Ti has been deposited. The thus obtained stack of germanium (2) and metal (5) has been annealed for 30 sec. using RTA (rapid thermal annealing) in an inert gas atmosphere. At several temperatures the corresponding sheet resistance of the stack is measured. The thus obtained resistance data is plotted in figure 3a in case of Ni, Co or Ti deposited on undoped germanium, while figure 3b shows the data for Ni deposited on germanium, doped with either Boron (B), Gallium (Ga), Phosphorus (P) or Antimony (Sb). The implant conditions (species, dose, energy) are indicated in figure 3b.

In a best mode embodiment of the invention Nickel (5) is deposited on a germanium layer (2).

In a first example the stack of Ni (5) and Ge (2) is heated to a temperature between 300°C and 600°C, preferably between 350°C and 450°C while the duration of this heating step is between 30 sec. and 10 minutes, preferably between 30 sec. and two minutes.

Figure 3a shows that in this temperature range a low resistive NiGe layer (6) is formed, having a sheet resistance below 10 Ohm/square. The unreacted Ni is selectively removed at (clean)room temperature using a wet etch composition of the invention.

In a second example the stack of Ni (5) and Ge (2) is first heated to a temperature between 150°C and 200°C while the duration of this first heating step is between 30 sec. and 10 minutes, preferably 30 sec. and two minutes. Figure 3a shows that in this range a Ni-rich germanium layer is formed having a sheet resistance between 10 and 20 ohm/square.

The unreacted Ni is removed at (clean)room temperature using a wet etch composition of the invention. Thereafter the Ni-rich germanium layer is converted into a NiGe layer (6) by heating the Ni-rich germanium layer to a temperature between 300°C and 600°C, preferably between 350°C and 450°C while the duration of this heating step is between 30 sec. and 10 minutes, preferably 30 sec. and two minutes.

The mixture of the present invention removes substantially all unreacted metal (5) selective to the compound of metal (5) and germanium (2).

If dielectric materials (4), (8), such as an oxide, a nitride, an oxynitride such as SixOyNx with $x+y+z \leq 1$, a silicon-carbide SiC or a siliconoxycarbide SixOyCx with $x+y+z \leq 1$, are present on the substrate (1), a composition of the present invention removes selectively the unreacted metal (5) to these dielectric materials.

Preferably, a (wet etch) composition of the invention doesn't comprise agents which oxidize (damage) the germanium layer (2). To avoid oxidation of Germanium, no concentrated (hot) $H_2SO_4$ is used because concentrated (hot) $H_2SO_4$ can oxidize Germanium.

A wet etch composition of the invention can further comprise additives to improve the etch selectivity or etch rate of the unreacted metal.

A composition of the invention preferably does not comprise hydrofluoric acid when the dielectric material (4), (8) comprises silicon-oxygen bonds.

A method of the invention can be carried out for obtaining a semiconductor device comprising regions where a self-aligned germanide is formed by selectively removing the unreacted metal by means of a composition, heated or not, comprising at least one hydrohalide, and optionally $H_2SO_4$. The device is characterized by the fact that no attack of the Germanide is observed and more than 99% of the unreacted metal is removed.

Such a semiconductor device can be a MOSFET comprising a source and drain region formed in a germanium layer and/or with a gate formed in a germanium layer.

## Examples

In the following examples, the etch solutions are dilutions from commercially available HCl, HF and $H_2SO_4$ solutions that are commonly used in VLSI processing.

The HCl starting solution used is a 37 wt % concentrated solution, the $H_2SO_4$ starting solution is a 95-97 wt % concentrated solution and the HF starting solution is a 49 wt% concentrated solution.

### *Example 1: Different HCl:$H_2O$ compositions and their effect on etching selectivity and etch rate.*

Different ratios of HCl:$H_2O$ were tested at (clean)room temperature ranging from 1:0 to 1:7.

At (clean)room temperature the etching rate for unreacted Ni increases with the HCl concentration.

At (clean)room temperature complete removal of the unreacted Ni is obtained in less than 60 seconds with a HCl:$H_2O$ composition having a volumetric ratio of 1:0.

Too high concentrations of HCl can however attack (even if at very slow rate) the NiGe, as shown in Figure 4(b).

### *Example 2: Effect of Temperature on etching selectivity and etch rates.*

An HCl:$H_2O$ composition having a volumetric ratio of 1:3 and a volumetric ratio of 1:7 are used at three different temperatures: (clean)room temperature, at 45°C and at 60°C.

Figure 5 (a) shows the etch rates of unreacted Ni (removal of Ni as a function of time) at different temperatures for the 1:3 ratio. The unreacted Ni is completely removed in 120 seconds, with a composition at a temperature of 60°C, the etch selectivity towards Ni-Germanide for said mixture is 78.

Figure 5 (d) shows the etch rates of unreacted Ni (removal of Ni as a function of time) at different temperatures for the 1:7 (HCl:$H_2O$) ratio. The unreacted Ni is completely removed in 120 seconds, with a composition at a temperature of 60°C, the etch selectivity towards Ni-Germanide for said mixture is 101.

Figure 5 (b) and 5(e) shows the etch rate of NiGe with said etch compositions at different temperatures. NiGe is not etched at all, in other words there is clearly no attack of the NiGe. Figure 9 shows additionally the SEM pictures of these Ni-Germanide surfaces subjected to said etch composition of 1:3 at different temperatures (30,45 and 60°C) and no damage is observed.

It can be concluded that for HCl concentrations lower than about 10 wt.%, based on the total weight of the composition, and independent from the temperature, the Ni is selectively removed (etched) from NiGe.

It can be also concluded that the selective etch rate is improved by heating said composition, without affecting the NiGe layer.

### *Example 3: Additions of $H_2SO_4$ to a HC1:$H_2O$ etching composition.*

Figure 6 (a) shows the etching of unreacted Ni with a HCl:$H_2SO_4$:$H_2O$ composition having a volumetric ratio of 1:0,5:3.

It can be inferred from Figure 5(a) and Figure 6 (a) that the etch rate of unreacted Ni is higher with an HCl:$H_2SO_4$:$H_2O$ (1:0,5:3) composition compared to a HCl:$H_2O$ (1:3) composition.

Higher temperatures lead to higher removal rates of unreacted Ni.

Nevertheless, as shown in Figure 6 (b), an HCl:$H_2SO_4$:$H_2O$ (1:0,5:3) composition at a temperature higher than 50° C is more aggressive towards the NiGe, which is slowly etched.

### *Example 4: Use of HF:$H_2O$ etching mixtures*

Different HF:$H_2O$ compositions with volumetric ratios varying from 1:24,5 up to 1:9 have been tested.

The results for selective removal (or selective etching) of unreacted Ni with a HF:$H_2O$ ratio of 1:24,5 and 1:9 are shown in figure 8 (a).

The use of a HF:$H_2O$ composition having a volumetric ratio of 1:9, at (clean)room temperature, resulted in a complete removal of the unreacted Ni in 360 seconds.

Figure 8 (b) shows the etching rate of NiGe with the two different HF:$H_2O$ compositions. It can be concluded that there is no attack of the germanide.

### *Example 5: Etch selectivity of HCl:$H_2O$ mixtures*

A lower concentration of HCl (e.g. HCl:H2O composition having a ratio of 1:7 compared to a ratio of 1:3) shows a better selective removal (in other words a better etch selectivity) (Figure 4). The etch selectivity of a 1:7 (HCl:H2O) etch mixture towards NiGe is 101 compared to an etch selectivity of 78 for a 1:3 (HCl:H2O) mixture. The Table below gives the different etch selectivities for the etch mixtures disclosed by the current invention:

| Temperature (°C) | Etch rate Ni (nm/min.) | Etch rate Ni-Ge (nm/min.) | selectivity |
|---|---|---|---|
| HCl:$H_2SO_4$:$H_2O$ (1:0.5:3) | | | |
| 20 | 1.48 | 0.20 | 7 |
| 50 | 6.77 | 0.65 | 10 |
| 70 | 46.65 | 1.90 | 25 |
| HCl:$H_2O$ (1:3) | | | |
| 30 | 1.16 | 0.11 | 11 |
| 45 | 4.13 | 0.16 | 26 |

(continued)

| Temperature (°C) | Etch rate Ni (nm/min.) | Etch rate Ni-Ge (nm/min.) | selectivity |
|---|---|---|---|
| 60 | 24.25 | 0.31 | 78 |
| $HCl:H_2O$ (1:7) | | | |
| 30 | 1.56 | 0.16 | 10 |
| 45 | 4.06 | 0.18 | 22 |
| 60 | 23.66 | 0.24 | 101 |

## Claims

**1.** Use of a composition comprising one or more hydrohalides, and optionally $H_2SO_4$, for the removal of unreacted metal(s) from a germanium layer, a germanide layer and/or a dielectric material.

**2.** Use of a composition according to claim 1 wherein said hydrohalides are selected from the group consisting of HCl, HF, HI and HBr.

**3.** Use of a composition according to claim 1 or 2 wherein said hydrohalide is HCl.

**4.** Use of a composition according to any of claims 1 to 3 wherein said unreacted metal is nickel (Ni).

**5.** Use of a composition according to any of claims 1 to 4 wherein the concentration of HCl is less than 37 wt%.

**6.** Use of a composition according to any of claims 1 to 4 wherein the concentration of HCl is less than 20 wt%.

**7.** Use of a composition according to any of claims 1 to 4 wherein the concentration of HCl is less than 10 wt%.

**8.** Use of a composition according to any of claims 1 to 7 wherein the concentration of said hydrohalide(s) is less than 37 wt%.

**9.** Use of a composition according to any of claims 1 to 8 wherein the temperature is between 18°C and 100°C.

**10.** Use of a composition according to any of claims 1 to 8 wherein the temperature is between 50°C and 80°C.

**11.** An aqueous composition comprising one or more hydrohalides and $H_2SO_4$.

**12.** An aqueous composition according to claim 11 wherein said hydrohalides are selected from the group consisting of HCl, HF, HI and HBr.

**13.** A method for forming a self-aligned germanide, comprising the step of removing unreacted metal from a germanium layer, a germanide layer and/or a dielectric material, by contacting said unreacted metal with a composition comprising one or more hydrohalides, and optionally $H_2SO_4$.

**14.** A method for forming a self-aligned germanide according to claim 13 wherein the temperature of the composition is comprised between 18°C and 100°C.

**15.** A semiconductor device comprising a self-aligned germanide from which the unreacted metal has been removed by a composition comprising one or more hydrohalides, and optionally $H_2SO_4$.

Figure 1

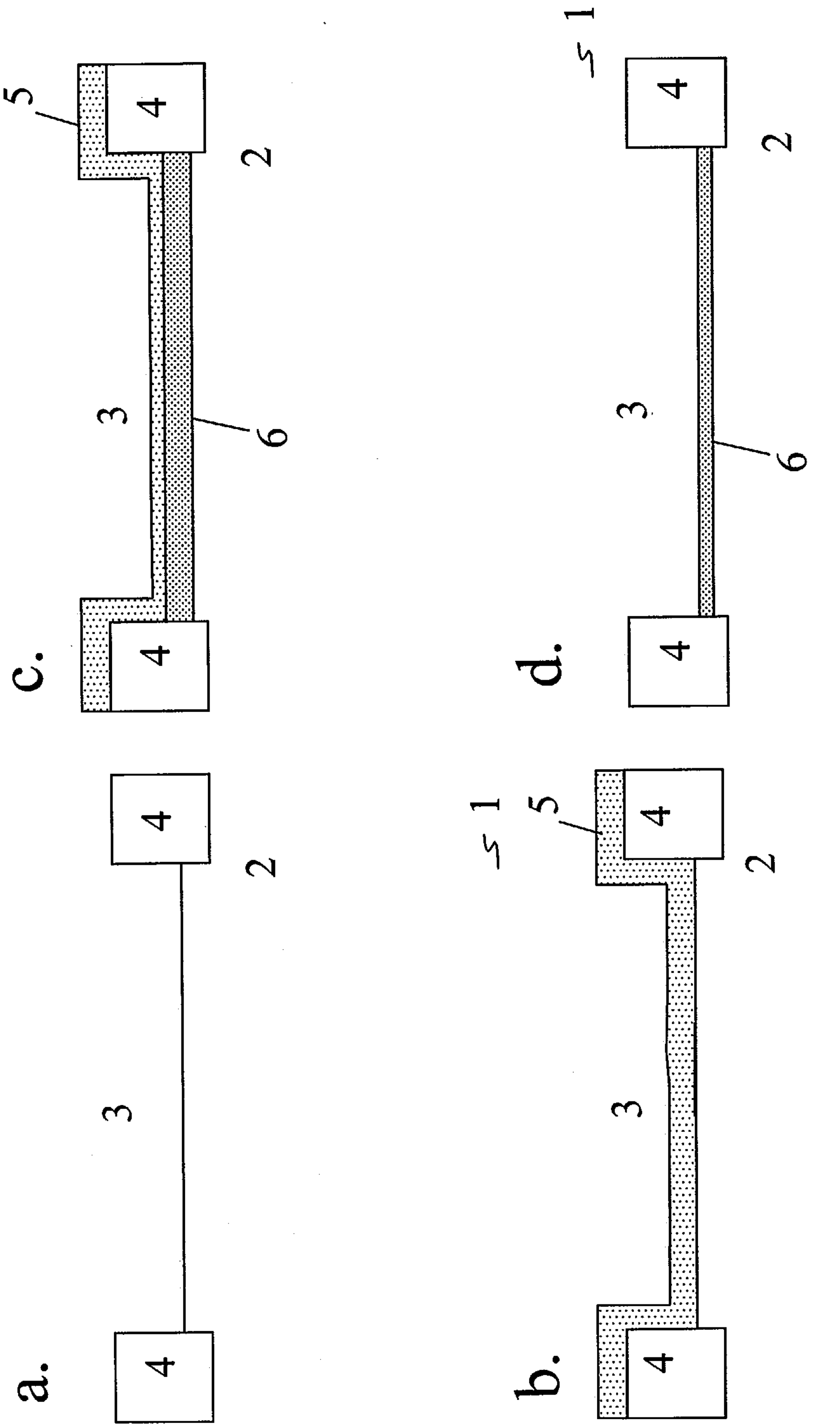

Figure 2

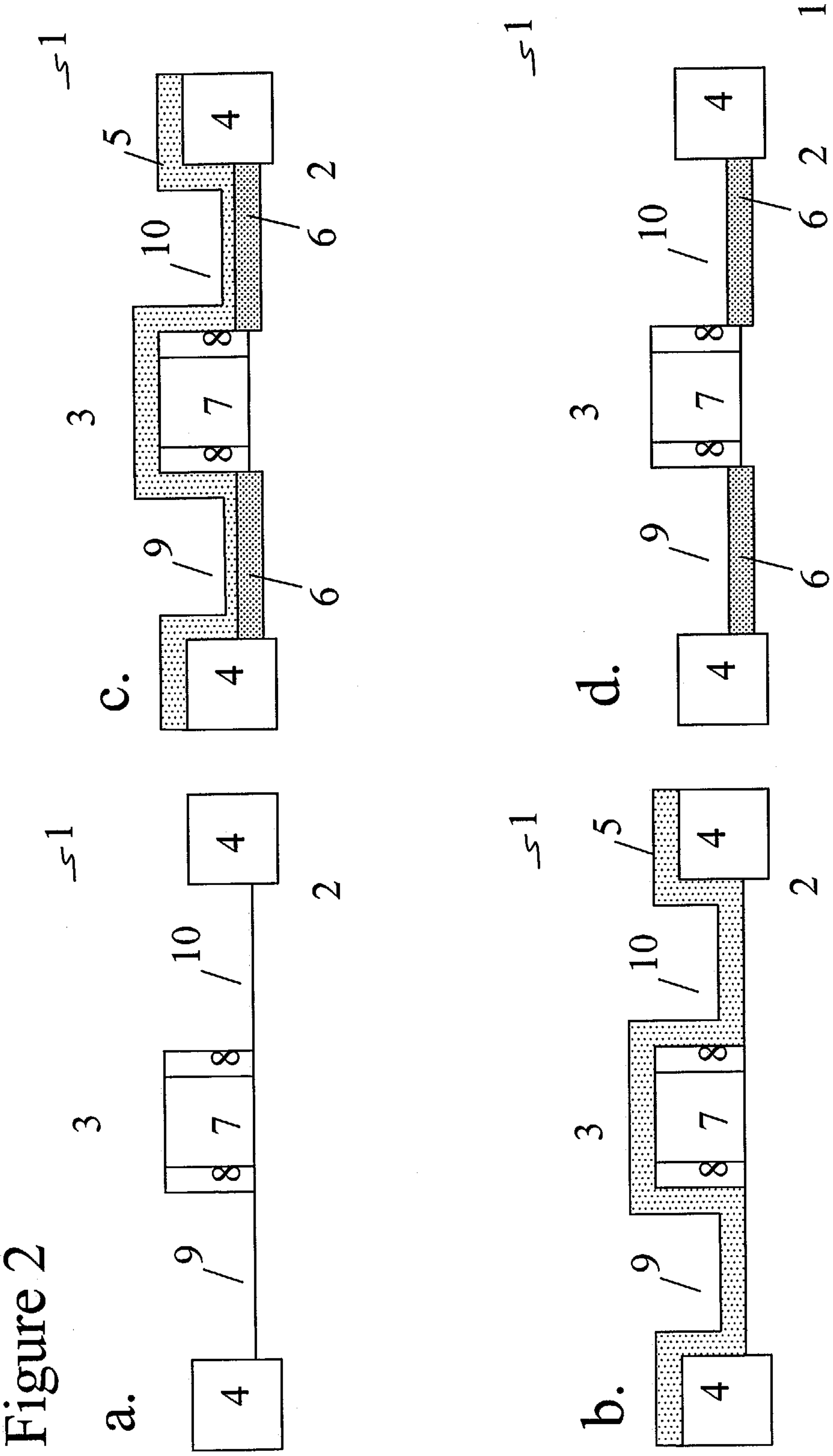

Figure 2
e.

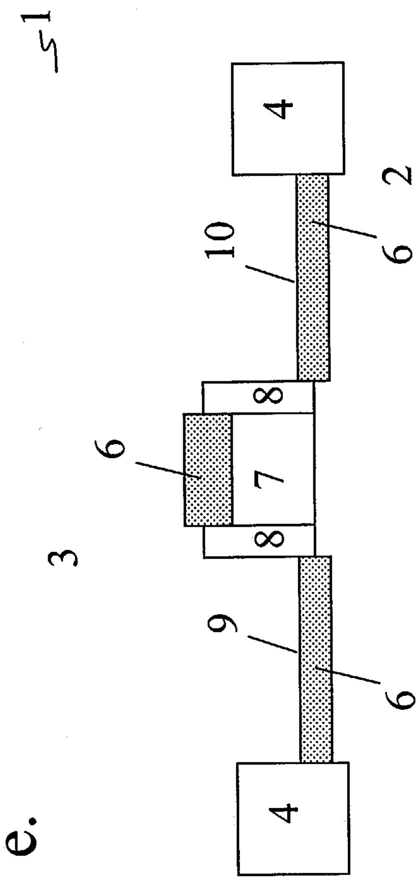

Figure 3a

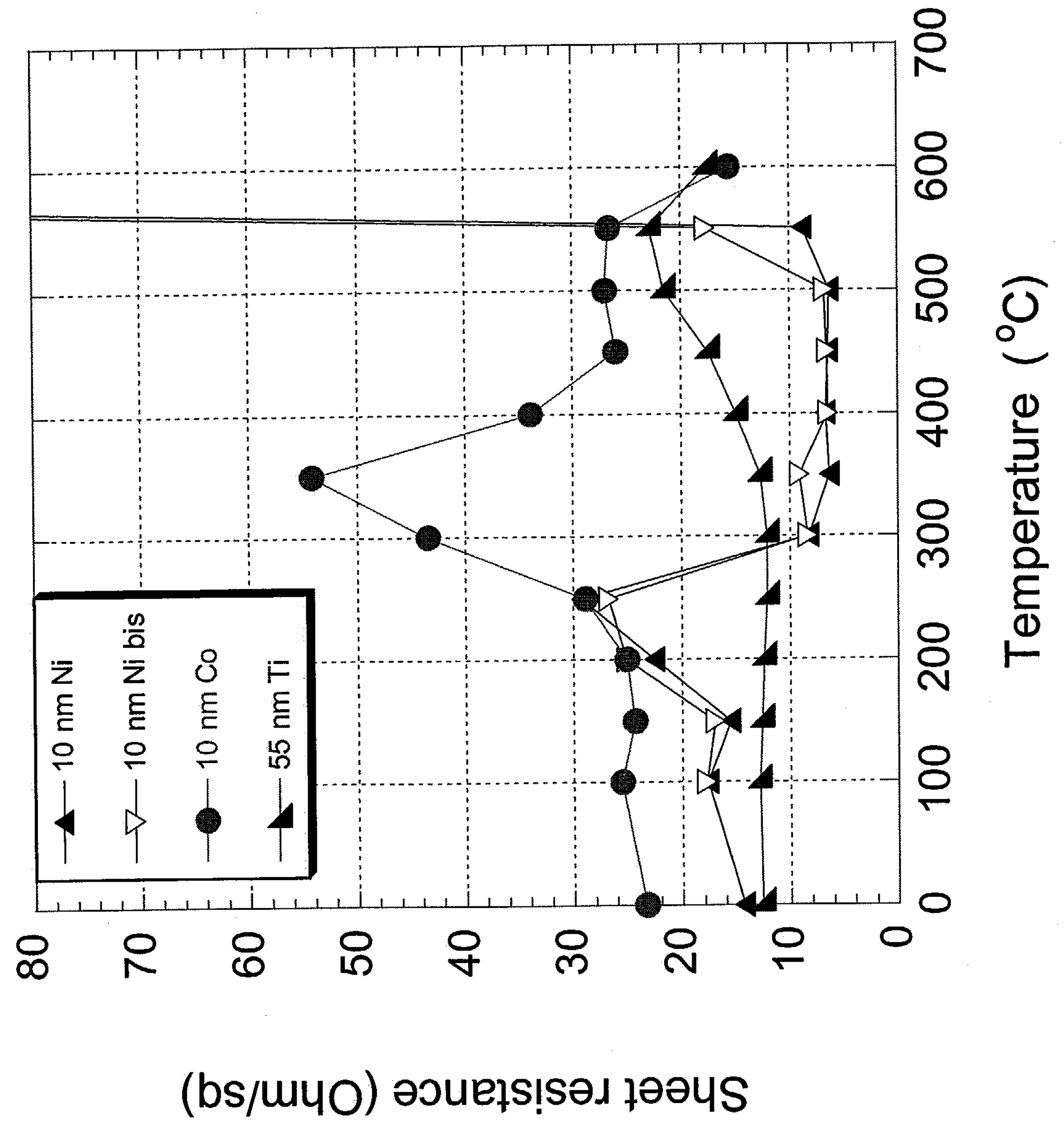
Sheet resistance (Ohm/sq)
Temperature (°C)
10 nm Ni
10 nm Ni bis
10 nm Co
55 nm Ti
0
10
20
30
40
50
60
70
80
100
200
300
400
500
600
700

Figure 3b

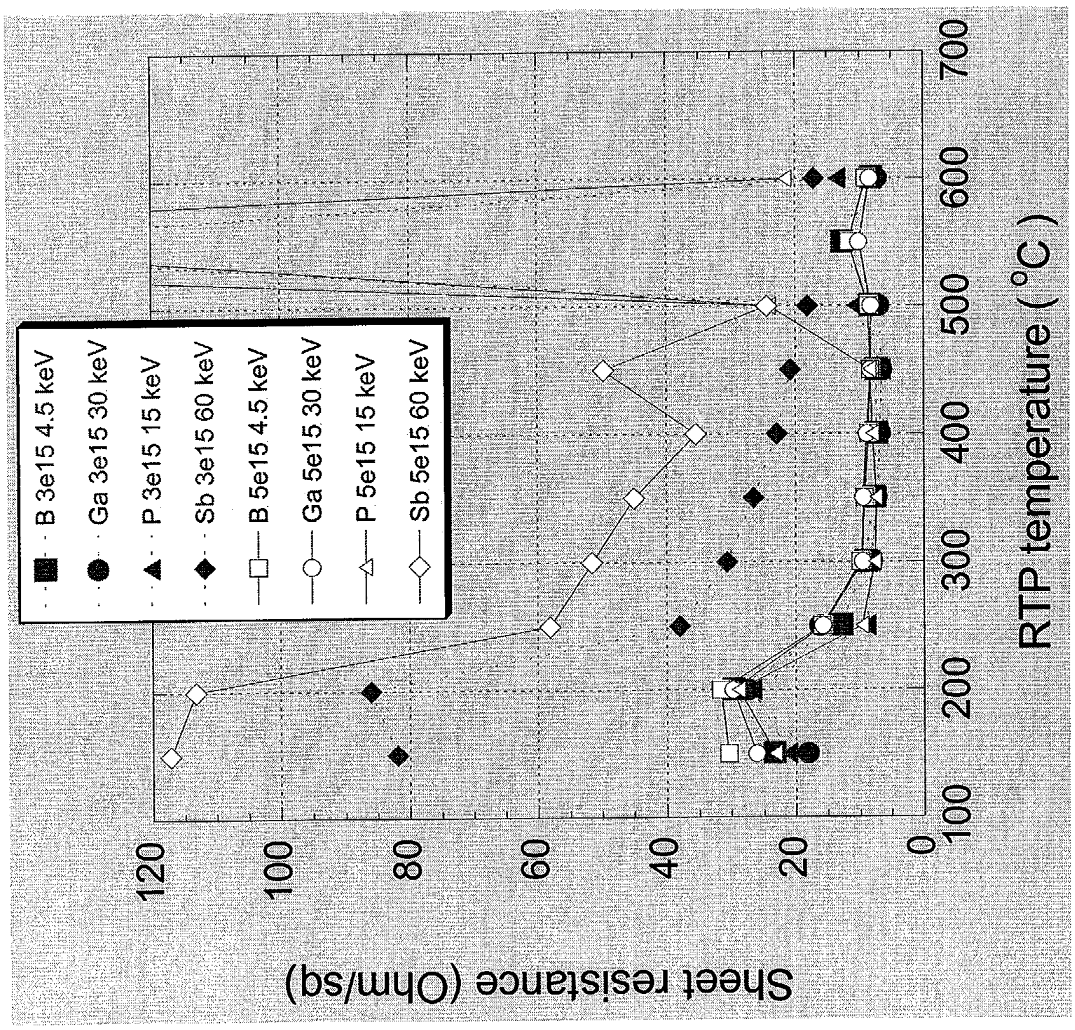
B 3e15 4.5 keV
Ga 3e15 30 keV
P 3e15 15 keV
Sb 3e15 60 keV
B 5e15 4.5 keV
Ga 5e15 30 keV
P 5e15 15 keV
Sb 5e15 60 keV
Sheet resistance (Ohm/sq)
120
100
80
60
40
20
0
100
200
300
400
500
600
700
RTP temperature (°C)

Figure 4a

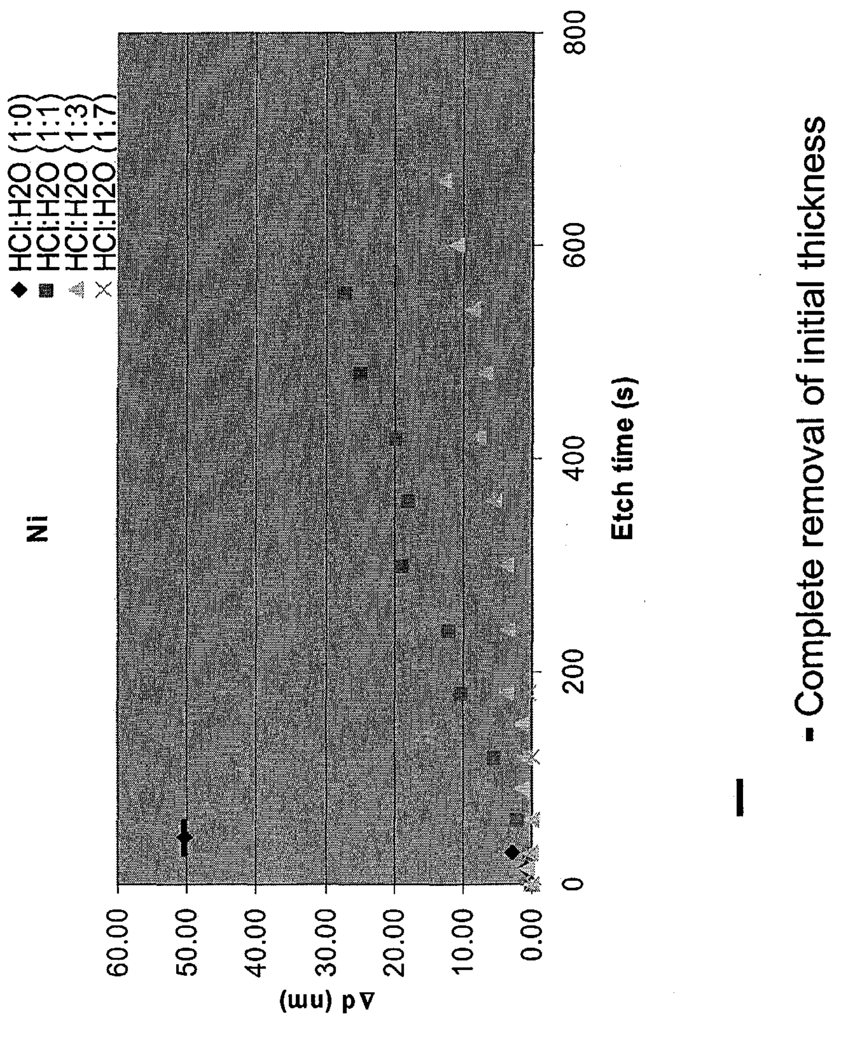
Ni
HCl:H2O (1:0)
HCl:H2O (1:1)
HCl:H2O (1:3)
HCl:H2O (1:7)
Δd (nm)
60.00
50.00
40.00
30.00
20.00
10.00
0.00
0
200
400
600
800
Etch time (s)
- Complete removal of initial thickness

Figure 4b

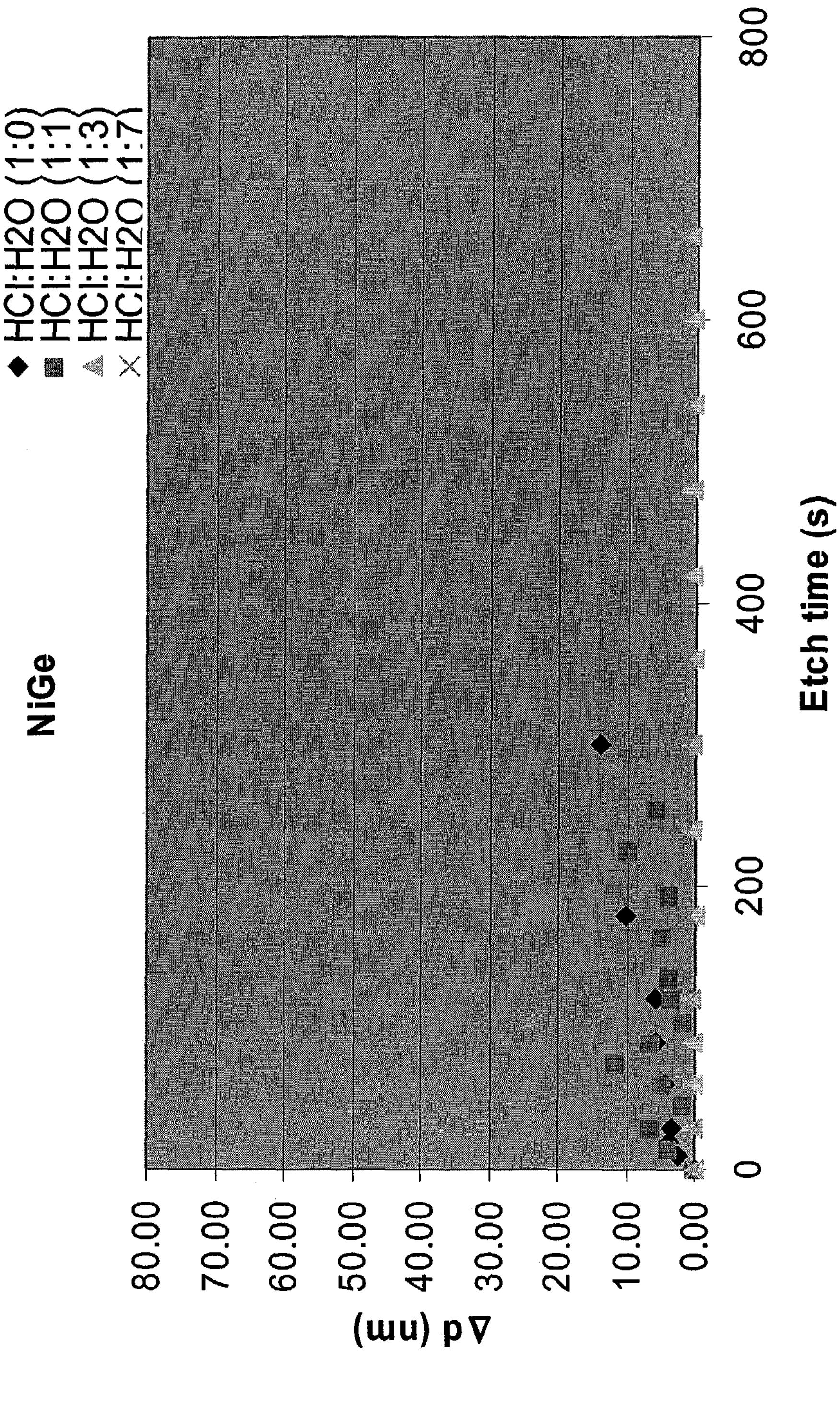
NiGe
HCl:H2O (1:0)
HCl:H2O (1:1)
HCl:H2O (1:3)
HCl:H2O (1:7)
Δd (nm)
80.00
70.00
60.00
50.00
40.00
30.00
20.00
10.00
0.00
0
200
400
600
800
Etch time (s)

Figure 5a

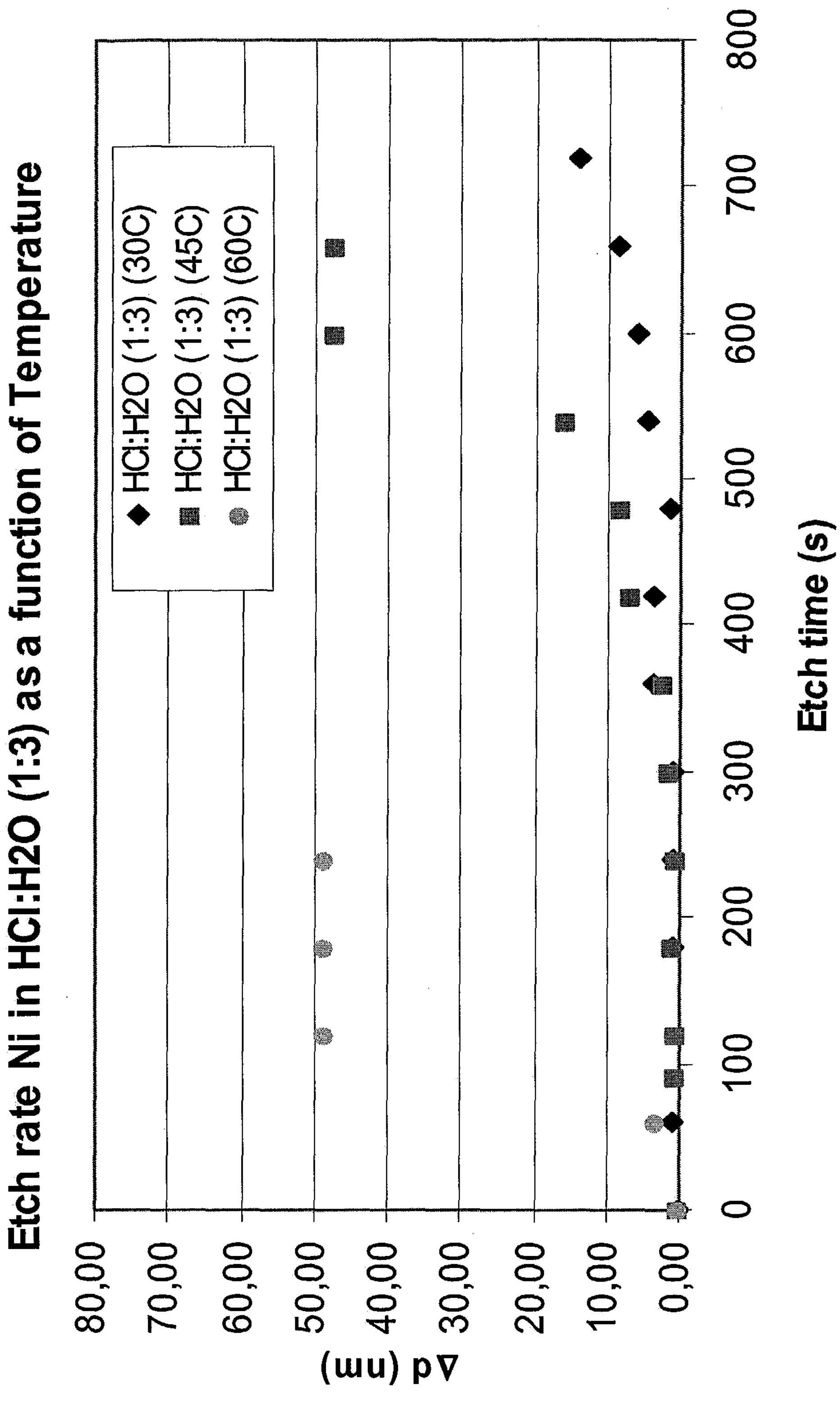
Etch rate Ni in HCl:H2O (1:3) as a function of Temperature
HCl:H2O (1:3) (30C)
HCl:H2O (1:3) (45C)
HCl:H2O (1:3) (60C)
Δd (nm)
80,00
70,00
60,00
50,00
40,00
30,00
20,00
10,00
0,00
0
100
200
300
400
500
600
700
800
Etch time (s)

Figure 5b

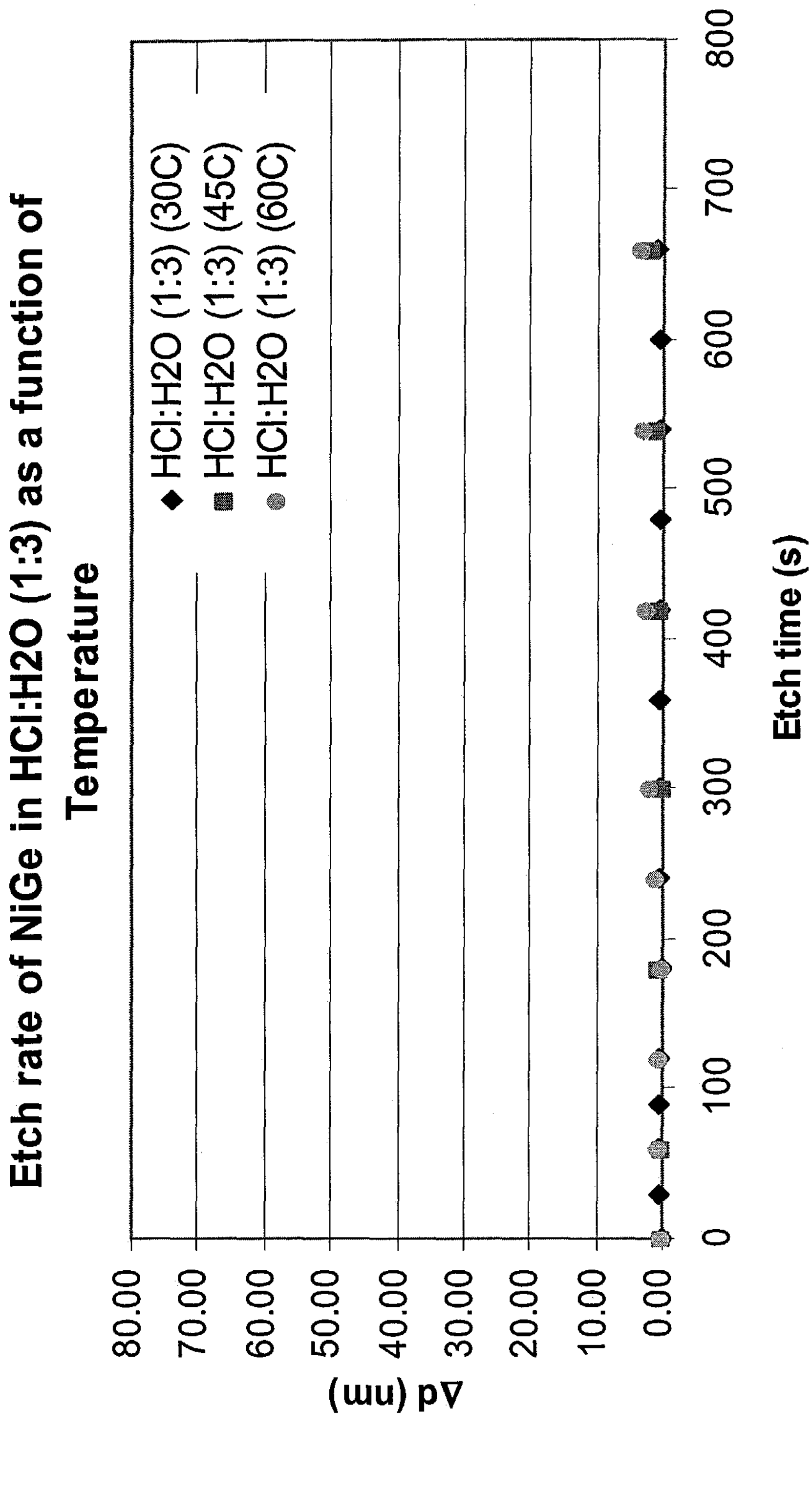
Etch rate of NiGe in HCl:H2O (1:3) as a function of Temperature
HCl:H2O (1:3) (30C)
HCl:H2O (1:3) (45C)
HCl:H2O (1:3) (60C)
Δd (nm)
80.00
70.00
60.00
50.00
40.00
30.00
20.00
10.00
0.00
0
100
200
300
400
500
600
700
800
Etch time (s)

Figure 5c

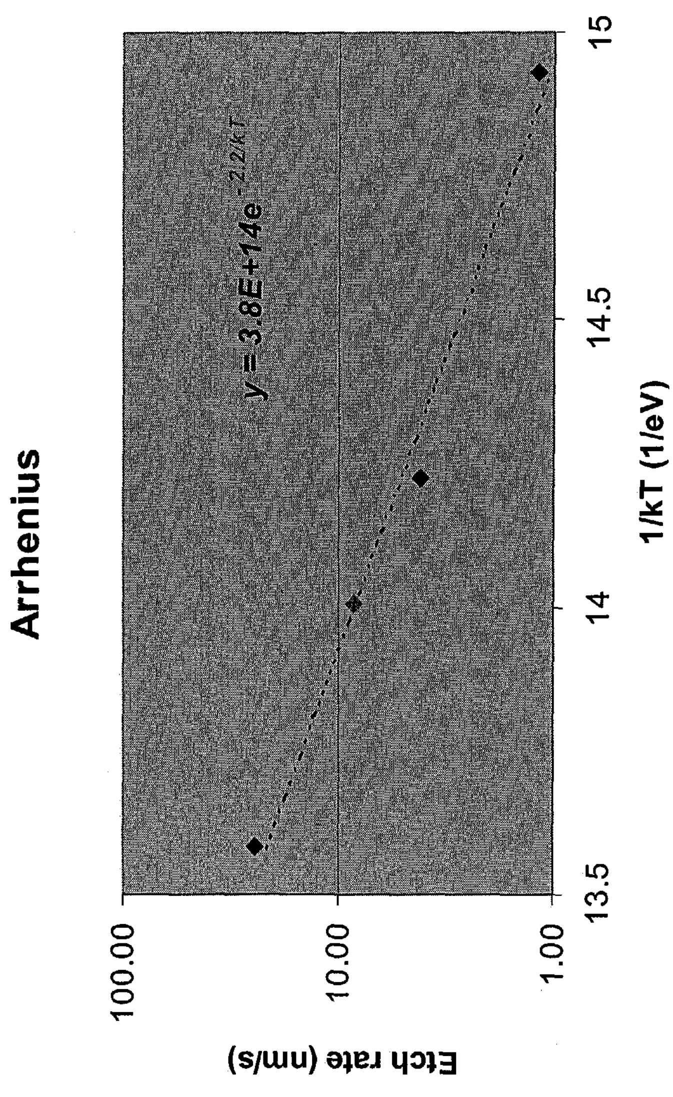


Activation energy: $E_a = 2.2$ eV

Figure 5d

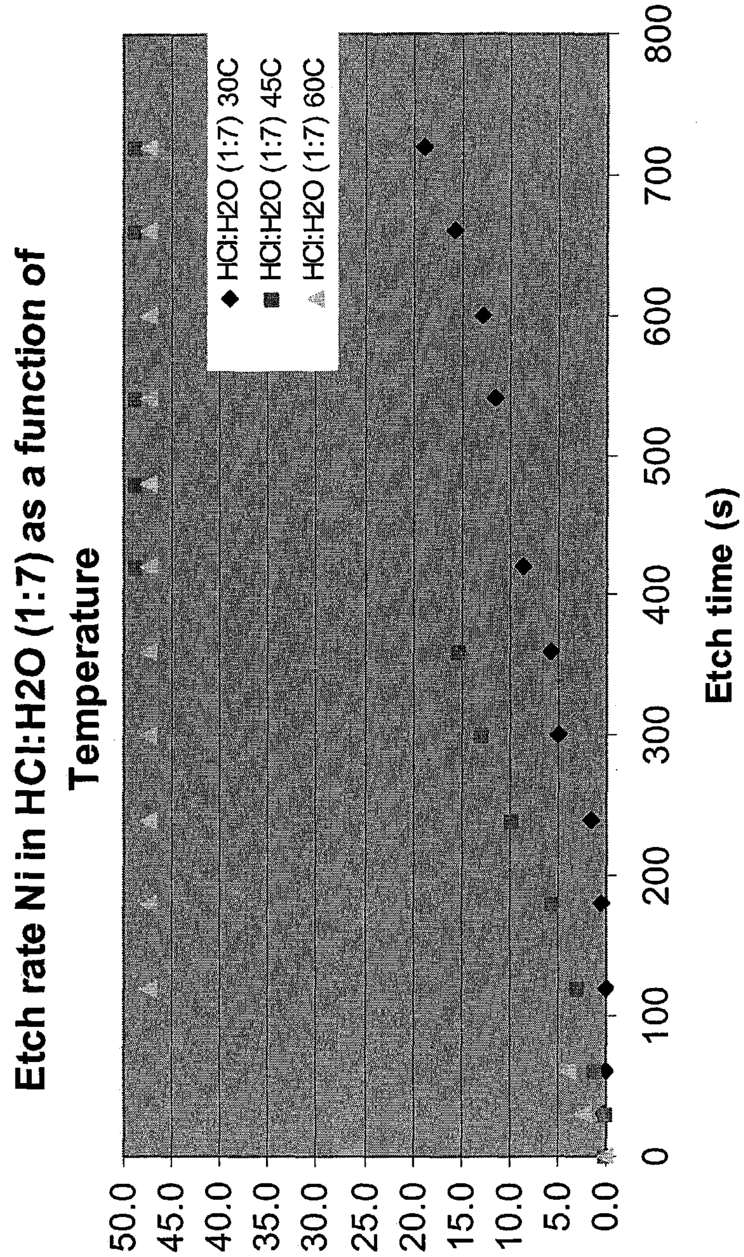
Etch rate Ni in HCl:H2O (1:7) as a function of Temperature
Δd (nm)
50.0
45.0
40.0
35.0
30.0
25.0
20.0
15.0
10.0
5.0
0.0
0
100
200
300
400
500
600
700
800
Etch time (s)
HCl:H2O (1:7) 30C
HCl:H2O (1:7) 45C
HCl:H2O (1:7) 60C

Figure 5e

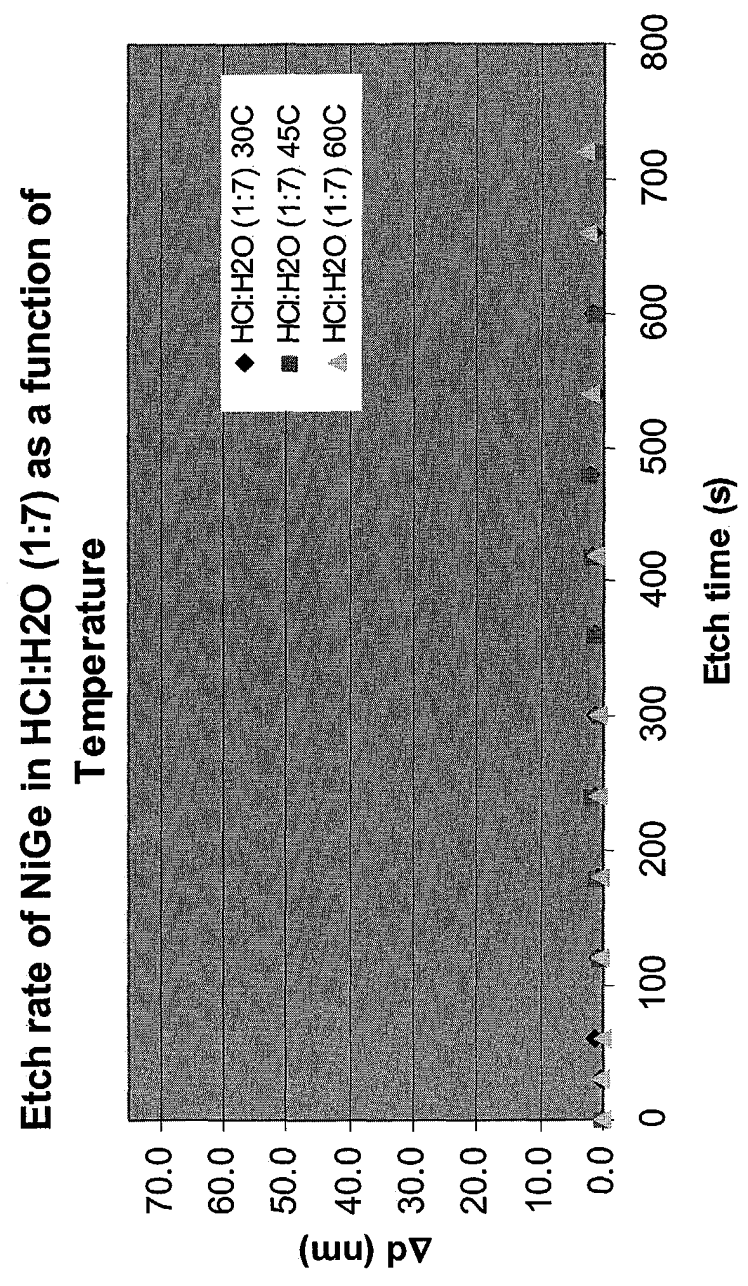
Etch rate of NiGe in HCl:H2O (1:7) as a function of Temperature
Δd (nm)
70.0
60.0
50.0
40.0
30.0
20.0
10.0
0.0
0
100
200
300
400
500
600
700
800
Etch time (s)
HCl:H2O (1:7) 30C
HCl:H2O (1:7) 45C
HCl:H2O (1:7) 60C

Figure 6a

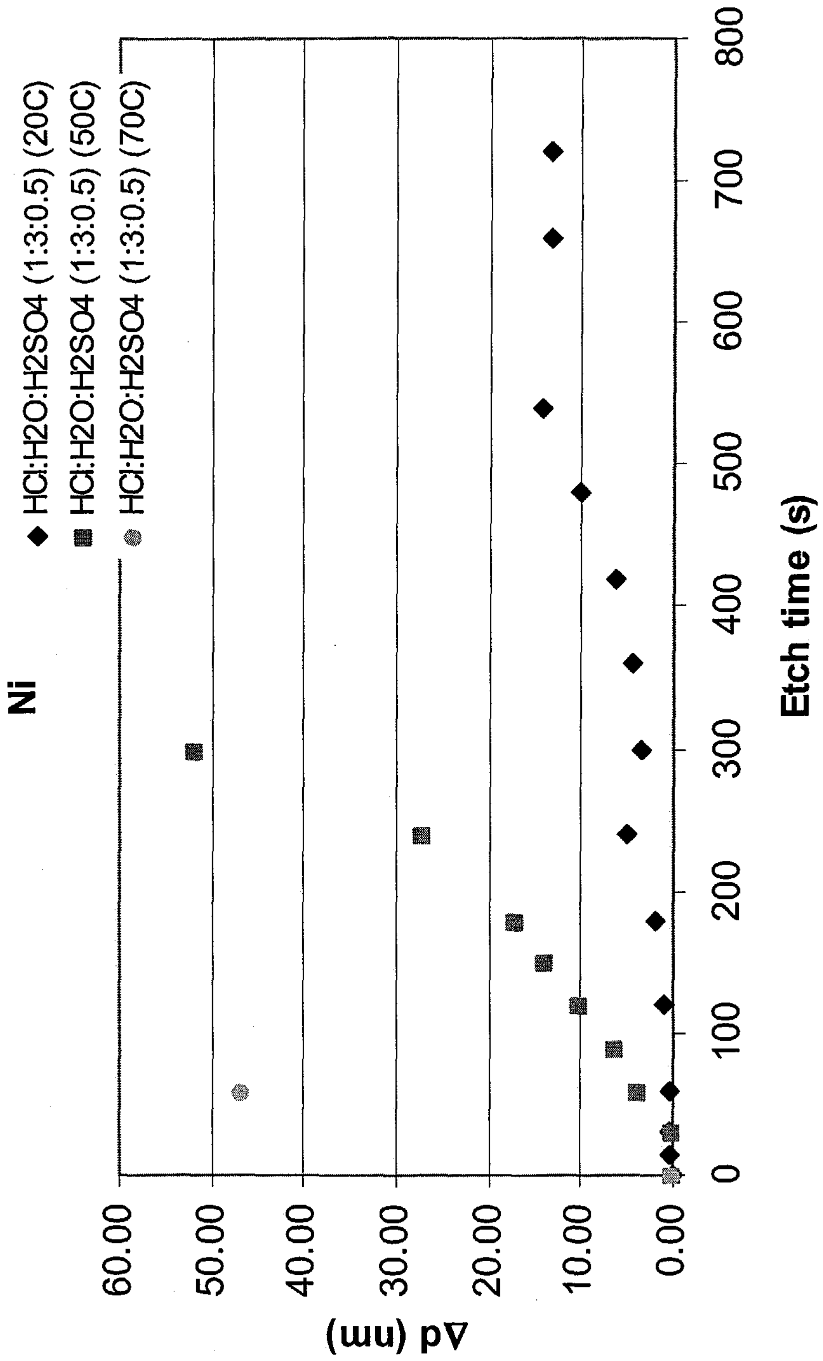
Ni
HCl:H2O:H2SO4 (1:3:0.5) (20C)
HCl:H2O:H2SO4 (1:3:0.5) (50C)
HCl:H2O:H2SO4 (1:3:0.5) (70C)
Δd (nm)
60.00
50.00
40.00
30.00
20.00
10.00
0.00
Etch time (s)
0
100
200
300
400
500
600
700
800

Figure 6b

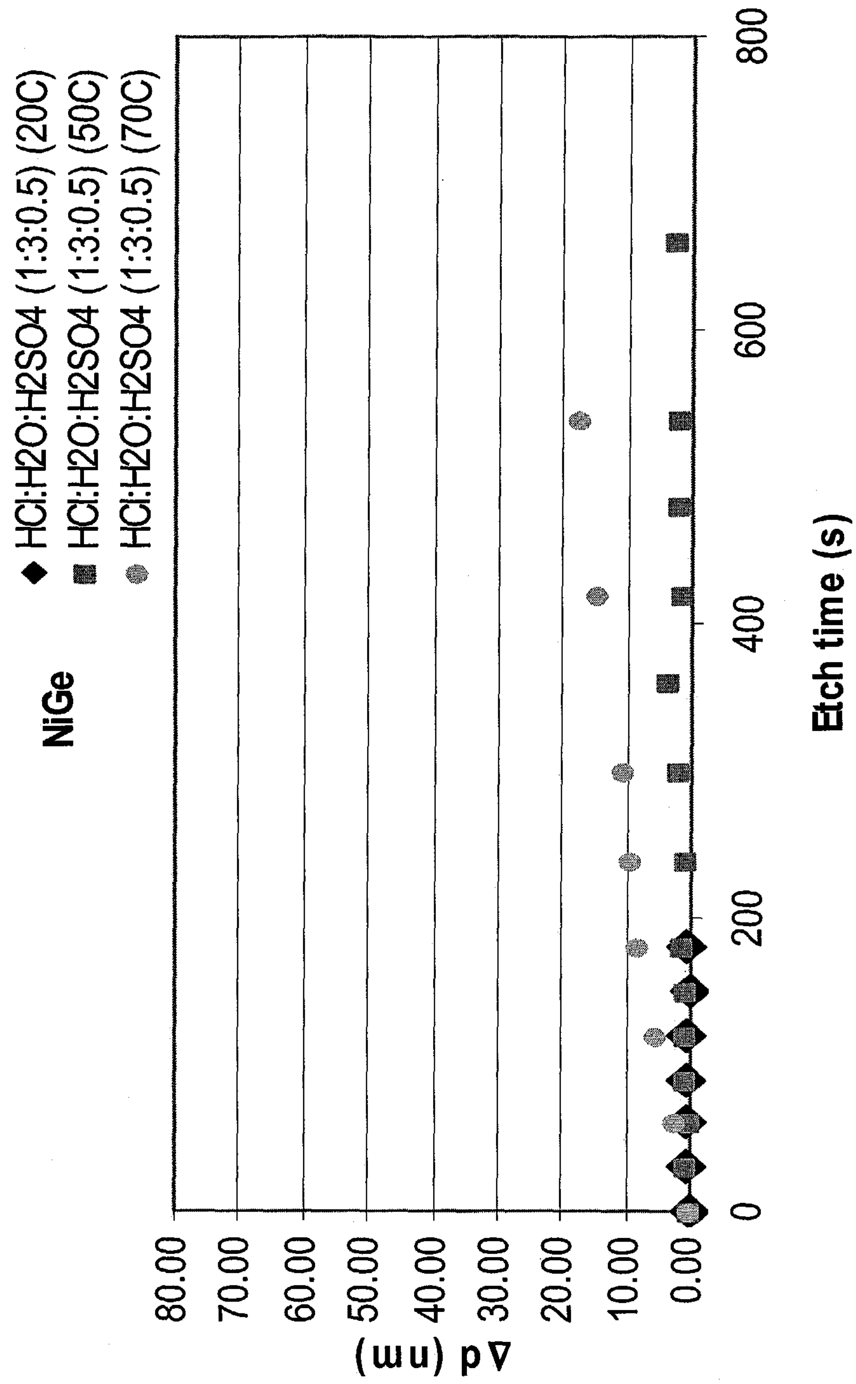
NiGe
HCl:H2O:H2SO4 (1:3:0.5) (20C)
HCl:H2O:H2SO4 (1:3:0.5) (50C)
HCl:H2O:H2SO4 (1:3:0.5) (70C)
Δd (nm)
80.00
70.00
60.00
50.00
40.00
30.00
20.00
10.00
0.00
0
200
400
600
800
Etch time (s)

Figure 6c

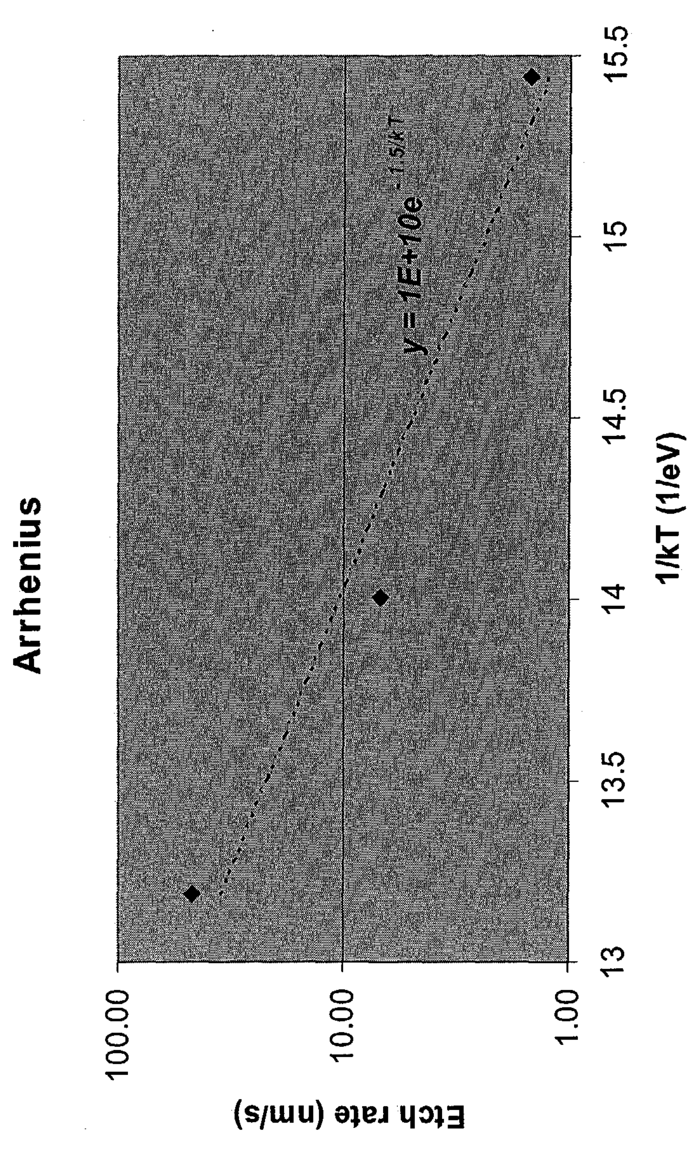


Activation energy: $E_a$ = 1.5 eV < 2.2 eV

Figure 7a

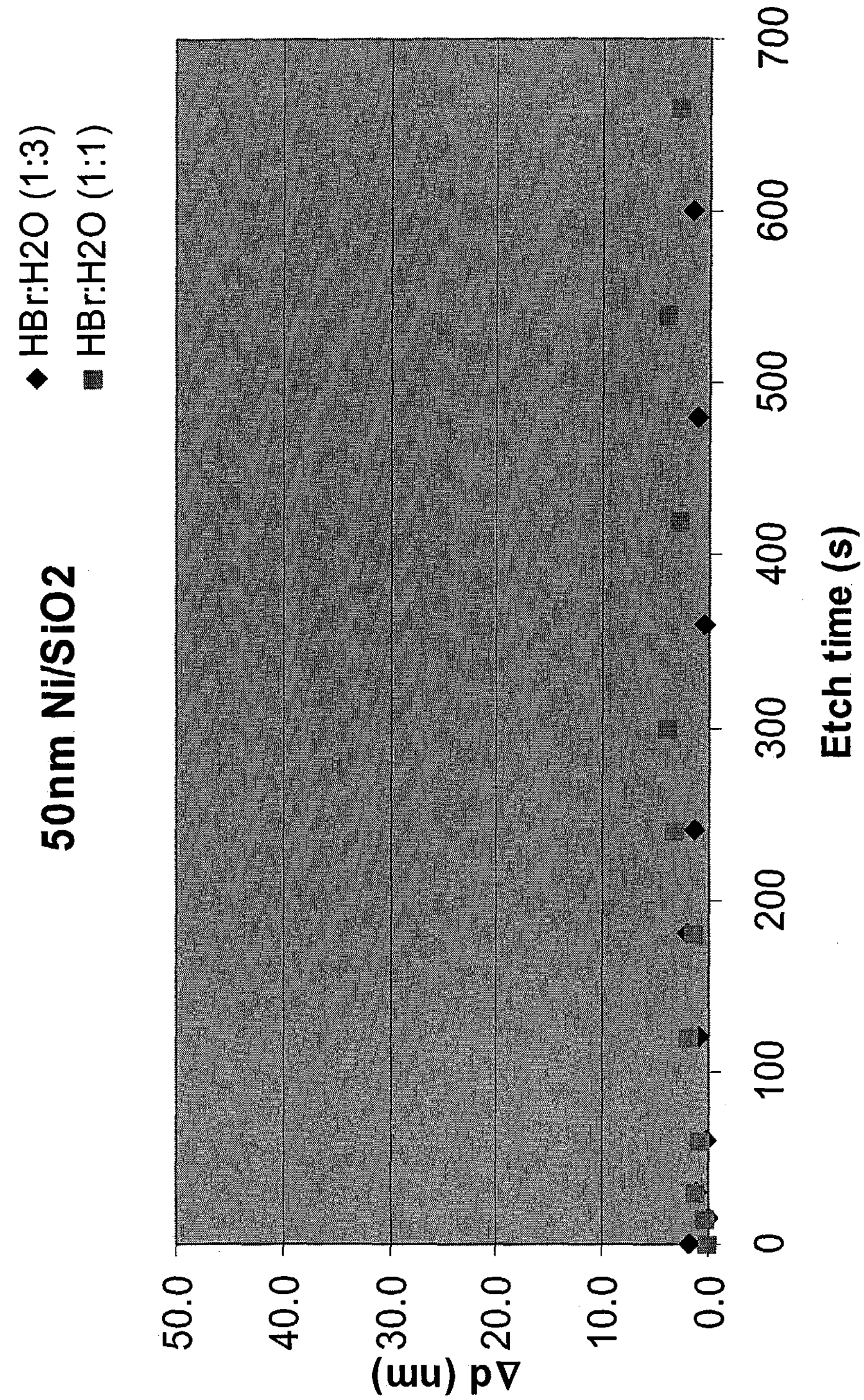
50nm Ni/SiO2
HBr:H2O (1:3)
HBr:H2O (1:1)
Δd (nm)
50.0
40.0
30.0
20.0
10.0
0.0
0
100
200
300
400
500
600
700
Etch time (s)

Figure 7b

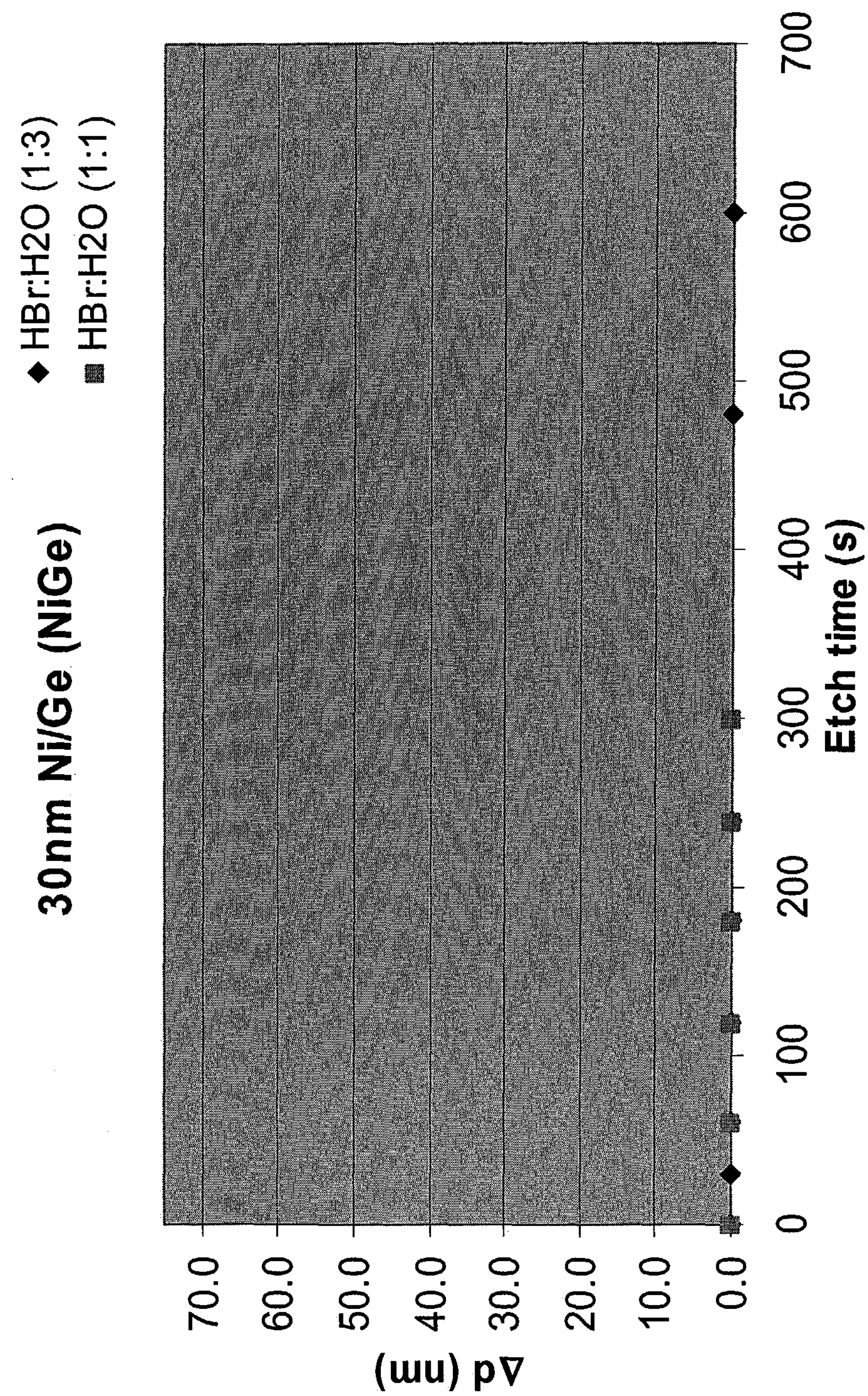
30nm Ni/Ge (NiGe)
HBr:H2O (1:3)
HBr:H2O (1:1)
Δd (nm)
70.0
60.0
50.0
40.0
30.0
20.0
10.0
0.0
0
100
200
300
400
500
600
700
Etch time (s)

Figure 8a

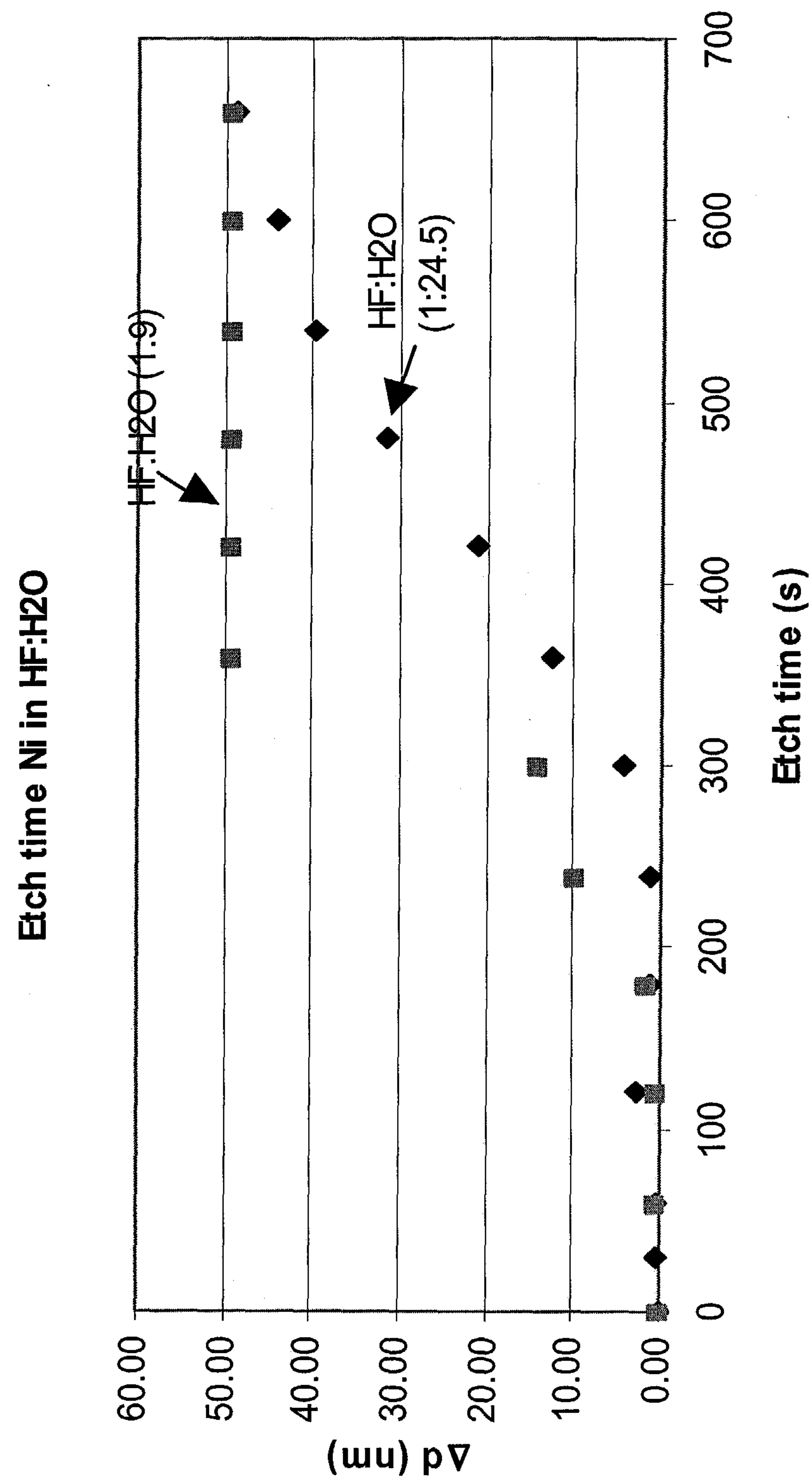
Etch time Ni in HF:H2O
HF:H2O (1:9)
HF:H2O
(1:24.5)
Δd (nm)
60.00
50.00
40.00
30.00
20.00
10.00
0.00
0
100
200
300
400
500
600
700
Etch time (s)

Figure 8b

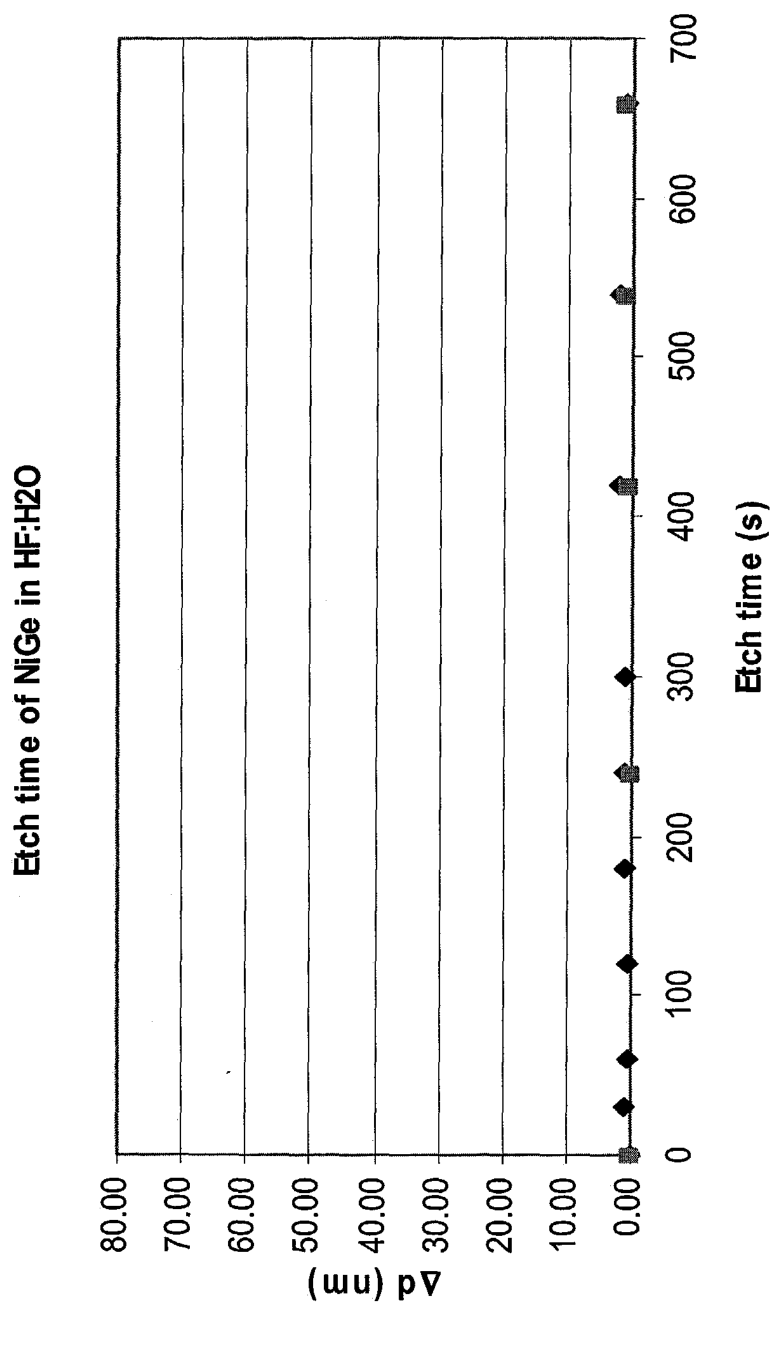
Etch time of NiGe in HF:H2O
Δd (nm)
80.00
70.00
60.00
50.00
40.00
30.00
20.00
10.00
0.00
0
100
200
300
400
500
600
700
Etch time (s)

Figure 9

30 °C

45°C

60°C